# EUROPÄISCHE PATENTSCHRIFT

(11) **EP 1 051 729 B1**
(45) Veröffentlichungstag und Bekanntmachung des Hinweises auf die Patenterteilung: **10.04.2002**
(21) Anmeldenummer: 99903659.3
(22) Anmeldetag: 20.01.1999
(51) Int. Cl.: H01J 37/32

(54) **PLASMAREAKTOR**
PLASMA REACTOR
REACTEUR A PLASMA

(30) Priorität: 27.01.1998 DE 19802971
(43) Veröffentlichungstag der Anmeldung: 15.11.2000
(73) Patentinhaber: FRAUNHOFER-GESELLSCHAFT ZUR FÖRDERUNG DER ANGEWANDTEN FORSCHUNG E.V., 80636 München (DE)
(72) Erfinder: WILD, Christof, D-79211 Denzlingen (DE); KOIDL, Peter, D-79211 Denzlingen (DE)
(74) Vertreter: Patent- und Rechtsanwaltssozietät, Maucher, Börjes & Kollegen
(86) Internationale Anmeldenummer: EP9900349
(87) Internationale Veröffentlichungsnummer: WO9938189

(56) Entgegenhaltungen:
- EP-A- 0 564 082
- EP-A- 0 593 931
- EP-A- 0 772 222
- EP-A- 0 778 608
- DE-A- 19 600 223
- US-A- 4 940 015
- US-A- 5 803 975

## Beschreibung

Die Erfindung bezieht sich auf einen Plasmareaktor mit einem als Resonator ausgebildeten Reaktorgehäuse, an das eine mit einem Hochfrequenzgenerator verbundene Hochfrequenz-Koaxialleitung zur Einstrahlung von Mikrowellen angeschlossen ist und in dem sich ein Substrathalter für ein zu beschichtendes Substrat befindet, wobei im Übergangsbereich von der Hochfrequenz-Koaxialleitung in das Reaktorgehäuse ein vakuumdichtes Fenster aus mikrowellendurchlässigem Material angeordnet ist und wobei das Reaktorgehäuse Anschlüsse zum Zu-und Ableiten eines Prozeßgases aufweist.

Aus der US 5 501 740 ist bereits ein ähnlicher Plasmareaktor bekannt. Bei diesem wird Mikrowellenenergie über eine Koaxial-Leitung unterhalb einer auch als Substrathalter dienenden Mikrowellen-Elektrode zugeführt, wobei der Innenleiter der Koaxial-Leitung unterseitig mit dem Substrathalter verbunden ist. Die plattenförmige Elektrode ist durch einen das Mikrowellenfenster bildenden, dielektrischen Ring mit dem Reaktorgehäuse verbunden.
Durch das Mikrowellen-Fenster erfolgt auch die Abdichtung des Reaktorgehäuses nach außen bzw. zu der Koaxial-Leitung. Im Reaktionsgehäuse herrscht ein gegenüber dem atmosphärischen Außendruck abgesenkter Innendruck, so daß auf den Substrathalter vergleichsweise hohe Kräfte wirken, die den mit dem Substrathalter verbundenen Innenleiter der Koaxial-Leitung zugbeanspruchen. Es sind demnach eine stabile Befestigung und äußere Verankerung des Innenleiters und entsprechend aufwendige mechanische Halterungsmaßnahmen erforderlich.
Nachteilig ist weiterhin, daß bei dieser Konstruktion der Substrathalter nur sehr schlecht zugänglich ist, so daß es schwierig und aufwendig ist, Techniken wie zum Beispiel die Substratkühlung, Substratrotation bzw. Positionierung, Temperaturkontrolle usw. zu realisieren. Insbesondere müssen hierbei in nachteiliger Weise Versorgungsleitungen durch den Innenleiter der Koaxial-Leitung geführt werden. Hierbei steht jedoch ein nur sehr begrenzter Raum zur Verfügung.

Aus der US 4 866 346 sowie der DE 195 07 077 sind Plasmareaktoren bekannt, bei denen der Substrathalter vergleichsweise gut zugänglich ist.
Bei der US 4 866 346 ist jedoch nachteilig, daß die Lage und Form des Plasmas sehr empfindlich von Prozeßparametern wie Gasdruck und eingekoppelter Mikrowellenleistung abhängt. Zudem sind diese beiden Prozeßparametern nicht unabhängig voneinander wählbar, sondern nur innerhalb eines verhältnismäßig engen Korrelationsbereiches in gegenseitiger Abhängigkeit einstellbar. Beim Verlassen dieses Korrelationsbereiches tritt häufig eine sprunghafte, räumliche Verschiebung des Plasmas auf, die neben einer Störung des Abscheidevorganges, beispielsweise ein das Reaktionsvolumen begrenzendes Quarzglas in kurzer Zeit zerstört. Ein weiterer Nachteil ist die starke Abhängigkeit der Lage des Plasmas von den geometrischen Randbedingungen und der Anordnung der Reaktionseinheit.
Mit der DE 195 07 077 läßt sich zwar eine sehr gute Plasmaform und Plasmastabilität erzielen, jedoch ist hierbei eine innerhalb des Reaktorgehäuses angeordnete, durch eine Quarzglocke umgrenzte Abscheidekammer, in der sich der Substrathalter befindet, vorgesehen. Dadurch ergeben sich ungünstige Größenverhältnisse, da der Resonator deutlich größer als die eigentliche Abscheidekammer ist.

Aus der EP 778 608 A2 ist ein Plasmagenerator und ein Verfahren zum Erzeugen eines Plasmas bekannt, wobei über mehrere Hohlleiter Mikrowellenenergie einem ringförmigen Verteilkanal zugeführt wird. Die Einstrahlung in den Reaktorraum erfolgt durch mehrere, am Umfang verteilt angeordnete Mikrowellen-Einkoppelfenster.

Aufgabe der vorliegenden Erfindung ist es, einen Plasmareaktor der eingangs erwähnten Art zu schaffen, bei dem das Substrat unter anderem für Kühlmaßnahmen, zur Positionierung, Temperaturkontrolle und dergleichen Maßnahmen gut und auf einfache Weise zugänglich ist. Außerdem soll das erzeugte Plasma stabil bezüglich der Plasmaposition, intensiv, räumlich ausgedehnt und homogen sein. Schließlich soll der Plasmareaktor insgesamt eine kompakte Bauform aufweisen.
Zur Lösung dieser Aufgabe wird vorgeschlagen, daß die Hochfrequenz-Koaxialleitung an ihrem Zuleitungsende außerhalb des Reaktorgehäuses trichterförmig und im wesentlichen rotationssymmetrisch aufgeweitet und am Umfang des Reaktorgehäuses gegen das im wesentlichen ringförmige, in Umfangsrichtung durchgehende Mikrowellen-Fenster für eine auf die gesamte Ringfläche des Mikrowellen- Fensters verteilte Einkopplung gerichtet ist.

Durch die außen am Umfangsbereich des Reaktorgehäuses erfolgende Mikrowellen-Einstrahlung steht praktisch das gesamte Innenvolumen des Reaktorgehäuses als Innenraum für die eigentliche Abscheidekammer zur Verfügung. Dementsprechend ergeben sich besonders günstige Größenverhältnisse des Reaktors mit dem Vorteil einer kompakten Bauform. Außerdem kann praktisch die gesamte Außenwand des Reaktorgehäuses und damit der Abscheidekammer einfach gekühlt werden, da sie gut zugänglich ist. Es besteht so auf besonders einfache Weise die Möglichkeit, daß die Reaktorwände weitgehendst aus doppelwandigen, metallischen, wassergekühlten Wänden bestehen.
Der ringförmigen Hohlleiterabschnitt in Verbindung mit dem umfangsseitig am Reaktorgehäuse angeordnete Mikrowellen-Fenster hat auch den Vorteil, daß das eingekoppelte Feld in Umfangsrichtung überall die gleiche Phase hat, was eine rotationssymmetrische Feld- und Plasmaverteilung ergibt. Außerdem ist die Einkopplung auf eine große Fläche verteilt. Dadurch können hohe Mikrowellenleistungen eingekoppelt werden, ohne daß am Mikrowellenfenster hohe elektrische Feldstärken entstehen und damit die Gefahr einer Fensterentladung. Dies ist insbesondere für die Stabilität der Plasmaposition eine wichtige Voraussetzung.
Besonders vorteilhaft ist hierbei auch, daß die Funktionsbereiche Mikrowellen-Einstrahlung einerseits und Substrathalter mit den dort angeordneten Elementen andererseits voneinander getrennte Funktionsbereiche bilden, die dann entsprechend den jeweiligen Anforderungen gestaltet und dimensioniert werden können. Insbesondere können dadurch unabhängig voneinander konstruktive Optimierungen vorgenommen werden.
Die voneinander getrennten Funktionsbereiche ergeben auch eine gute Zugänglichkeit des Substrathalters und damit insbesondere konstruktiv einfache Zuführungen, zum Beispiel für Kühlmittel und Mittel zum Positionieren (z.B. Substratrotation) sowie zur Temperaturkontrolle und dergleichen.

Eine vorteilhafte Ausgestaltung der Erfindung sieht vor, daß das Reaktorgehäuse in zwei voneinander elektrisch isolierte Teilgehäuse aufgeteilt ist, daß mit zumindest einem dieser Teilgehäuse ein Substrathalter verbunden ist und daß das andere, davon elektrisch isolierte Teilgehäuse vorzugsweise als Elektrode für eine Gleichspannungs- beziehungsweise Hochfrequenzentladung dient.

Das in Umfangsrichtung durchgehend ringförmig ausgebildete Mikrowellen-Fenster besteht dabei zweckmäßigerweise aus elektrisch isolierendem, mikrowellendurchlässigem Material, vorzugsweise Quarz und ist zwischen den beiden Teilgehäusen als Isolator eingefügt.
In diesem Fall bildet das Mikrowellen-Fenster selbst den Isolator zwischen den Teilgehäusen, so daß ein zusätzlicher Isolator entbehrlich und der Aufbau dadurch vereinfacht ist. Die Verwendung von Quarz für das Mikrowellen-Fenster hat den Vorteil, daß ein solches Fenster auch sehr hohen Temperaturgradienten widersteht.

Gegebenenfalls ist der Anschluß zum Zu-beziehungsweise Ableiten eines Prozeßgases dem Substrathalter gegenüberliegend angeordnet und vorzugsweise etwa mittig auf den Substrathalter gerichtet. Durch diese zentrale Gasführung wird eine homogene Beschichtung und dabei auch eine hohe Rotationssymmetrie bei der Abscheidung begünstigt.

Eine abgewandelte Ausführungsform der Erfindung sieht vor, daß mit beiden Teilgehäusen jeweils vorzugsweise ein Substrathalter verbunden ist und daß diese Substrathalter insbesondere direkt.... gegenüberliegend und vorzugsweise beide in einem gemeinsamen Bereich hoher Feldstärke angeordnet sind.
Dadurch ist die gleichzeitige Beschichtung zweier Substrate und damit eine energetisch vorteilhafte, wirtschaftliche Bearbeitung möglich.
Bedarfsweise kann der durch das Reaktorgehäuse gebildete Resonator auch so ausgebildet sein, daß sich räumlich getrennte Bereiche hoher beziehungsweise maximaler Feldstärke ergeben, in denen dann die Substrathalter angeordnet sind.

Zusätzliche Ausgestaltungen der Erfindung sind in den weiteren Unteransprüchen aufgeführt. Nachstehend ist die Erfindung mit ihren wesentlichen Einzelheiten anhand der Zeichnungen noch näher erläutert.

Es zeigt etwas schematisiert:
- Fig.1: eine Seitenansicht eines Plasmareaktors mit einem in dessen Gehäuse angeordneten Substrathalter und
- Fig.2: eine Teilansicht eines im wesentlichen Figur 1 entsprechenden Plasmareaktors, hier jedoch mit zwei gegenüberliegend im Reaktorgehäuse angeordneten Substrathaltern.

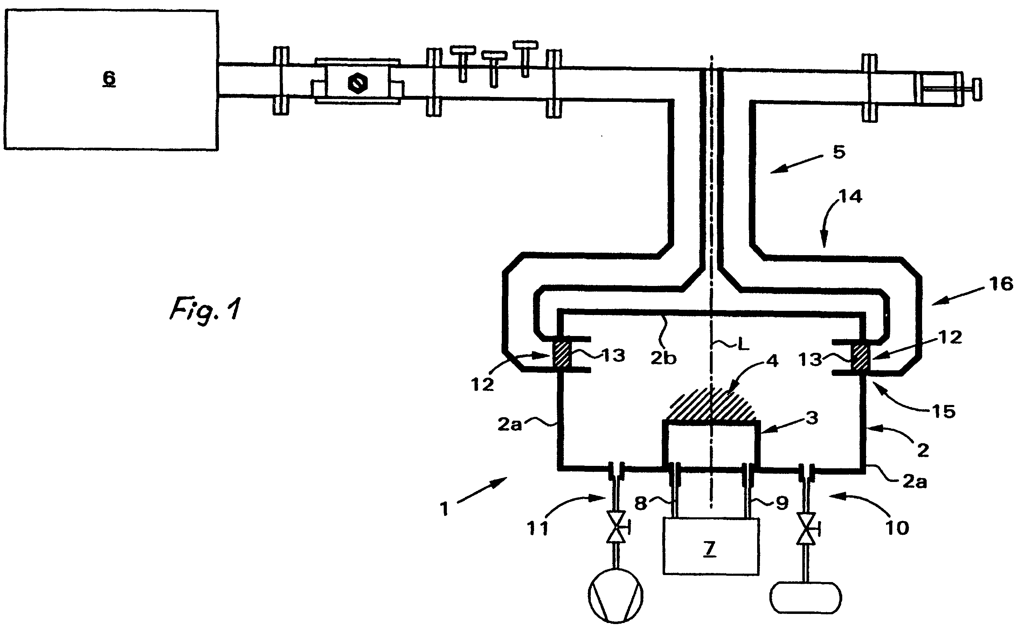

Ein in Fig.1 schematisch dargestellter Plasmareaktor 1 weist ein als Resonator ausgebildetes Reaktorgehäuse 2 auf, in dem sich ein Substrathalter 3 befindet. Auf diesem Substrathalter 3 läßt sich ein Substrat positionieren, das dann mit Hilfe eines Plasmas 4 beschichtet werden kann.
Der Plasmareaktor 1 eignet sich bevorzugt für die Diamant-CVD (chemical vapour deposition) und auch andere Anwendungen wie z.B. die Plasmadeposition anderer Materialien, die Plasmaoberflächenbehandlung und das Plasmaätzen.

Wie bereits vorerwähnt, eignet sich der Plasmareaktor bevorzugt auch für die Diamant-CVD, weil damit eine Plasmaabscheidung großflächiger Diamantscheiben durch Erzeugung von Mikrowellen-Plasmen bei relativ hohen Gasdrücken und hohen Leistungen möglich ist.
An das Reaktorgehäuse 2 ist eine Hochfrequenz-Koaxialleitung 5 zur Einstrahlung von Mikrowellen in das Reaktorgehäuse 2 angeschlossen, die andererseits mit einem Mikrowellengenerator 6 verbunden ist.
An das Reaktorgehäuse ist weiterhin noch eine Kühleinrichtung 7 mit einem Kühlflüssigkeitseinlaß 8 sowie einem Kühlflüssigkeitsauslaß 9 angeschlossen, mittels der der Substrathalter gekühlt werden kann. Schließlich sind in Fig.1 noch ein Gaseinlaß 10 und ein Gasauslaß 11 erkennbar, um Prozeßgas ins Innere des Reaktorgehäuses 2 leiten zu können. Wird beispielsweise ein kohlenstoffhaltiges Reaktionsgas verwendet, so läßt sich auf einem Substrat Diamant abscheiden.
Durch Einstrahlung von Mikrowellenstrahlung wird das Plasma 4 gezündet, wobei die Position des Plasmas von der Feldstärkeverteilung der Mikrowellen innerhalb des Reaktorgehäuses abhängt. In Abweichung von der nur schematischen Darstellung gemäß Fig.1 kann dementsprechend das Reaktorgehäuse so geformt oder ausgebildet sein, daß sich im Bereich des Substrates eine Zone hoher bzw. maximaler Feldstärke ergibt und damit ein optimales Plasma in diesem Bereich ermöglicht.

Die Koaxial-Leitung 5 ist an ihrem Zuleitungsende außerhalb des Reaktorgehäuses 2 aufgeteilt und am Außenumfang des Reaktorgehäuses 2 gegen ein im wesentlichen ringförmiges Mikrowellen-Fenster 12 gerichtet. In der Praxis ist dieses Fenster 12 durch einen Quarzring 13 gebildet, der dicht mit den angrenzenden Gehäusebereichen verbunden ist. Wie gut in Fig.1 erkennbar, ist das Reaktorgehäuse 2 rotationssymmetrisch bezüglich einer strichpunktiert eingezeichneten Längsmittelachse L ausgebildet.

Das Reaktorgehäuse 2 kann in einer die Längsmittelachse L enthaltenden Schnittebene rechteckig, vieleckig, rund oder gekrümmt sein. Beispielsweise besteht auch die Möglichkeit, das Gehäuse als Ellipsoid auszubilden.

Das Mikrowellen-Fenster 12 liegt in einer Ebene, die zur Auflage oder Befestigungsseite des Substrathalters 3, im Ausführungsbeispiel der Oberseite, beabstandet angeordnet ist. Die genaue Lage relativ zueinander kann entsprechend den praktischen Erfordernissen variiert werden.
Der das Mikrowellen-Fenster 12 bildende Quarz-Ring 13 ist insbesondere umlaufend in Umfangsrichtung durchgehend ausgebildet, so daß das Reaktorgehäuse 2 in zwei voneinander elektrisch isolierte Teilgehäuse 2a und 2b aufgeteilt ist. Dadurch besteht unter anderem die Möglichkeit, das Oberteil 2b als Elektrode für eine zusätzliche Gleich- bzw. Hochfrequenzspannung zu verwenden. Deutlich ist in Fig.1 auch erkennbar, daß der Einstrahlbereich für die Mikrowelle und der Substrathalter-Bereich mit den dort auch befindlichen Anschlüssen für Prozeßgas, Kühlflüssigkeit, Temperaturmessung, Substratrotation und dergleichen räumlich voneinander getrennt sind. Die einzelnen Bereiche und dort vorgesehenen Einrichtungen sind somit nicht gegenseitig hinderlich. Durch die Trennung der einzelnen Bereiche ist somit eine wesentlich bessere Zugänglichkeit insbesondere auch des Substrathalters vorhanden.

Die an ihrem Zuleitungsende außerhalb des Reaktorgehäuses 2 aufgeteilte Hochfrequenz-Koaxialleitung 5 ist im wesentlich trichterförmig erweiterert und von außen an das Mikrowellen-Fenster 12 herangeführt. Die Koaxial-Leitung ist dazu im Übergangsbereich zum Reaktorgehäuse zentral an einen flachen, tellerförmigen Hohlleiterabschnitt 14 angeschlossen, an den sich außenseitig ein ringförmiger und mit seinem Austrittsende 15 dem Mikrowellen-Fenster 12 außenseitig zugewandter Umlenk-Hohlleiterabschnitt 16 anschließt. Die Einkopplung der Mikrowelle in die Reaktorkammer ist somit rotationssymmetrisch und auf die gesamte Ringfläche des Mikrowellen-Fensters 12 verteilt.

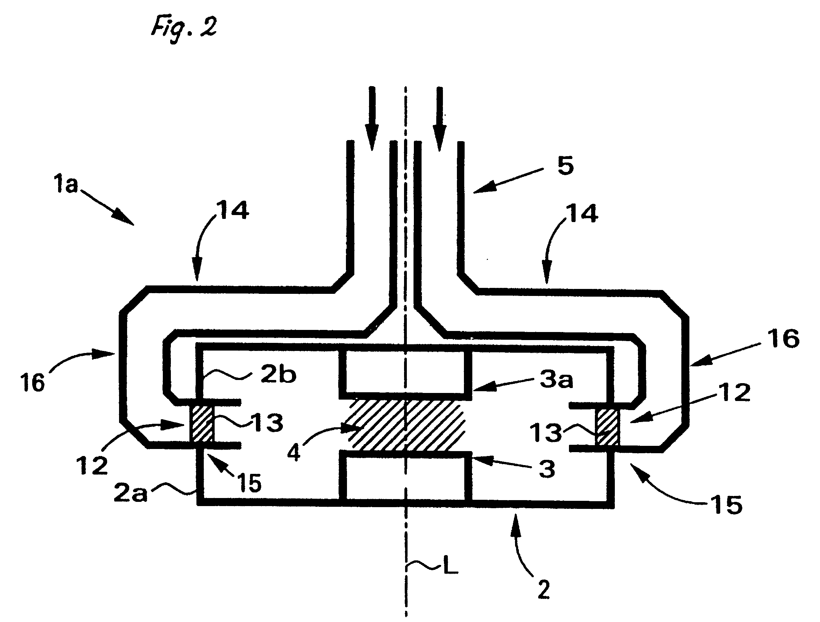

Fig.2 zeigt einen Plasmareaktor 1a, der im wesentlichen wie der in Fig.1 gezeigte Plasmareaktor 1 aufgebaut ist. Im Unterschied dazu sind innerhalb des Reaktorgehäuses 2 zwei gegenüberliegend und zentral innerhalb des vorzugsweise rotationssymmetrischen Reaktorgehäuses 2 angeordnete Substrathalter 3, 3a vorgesehen. Die einander zugewandten Seiten der beiden Substrathalter dienen als Auflage jeweils für ein Substrat. Im vorliegenden Ausführungsbeispiel sind die beiden Substrathalter 3, 3a so angeordnet, daß sich die dort angeordneten Substrate im Kontakt mit einem gemeinsamen Plasma 4 befinden, wie dies schraffiert angedeutet ist. Es besteht aber auch die Möglichkeit, eine Reaktorgehäuse-Form zu wählen, bei der sich die beiden Substrathalter in voneinander getrennten Bereichen hoher Feldstärke befinden, so daß sich jeweils auch dort getrennte Plasmen ausbilden.
In Fig.2 ist noch gut zu erkennen, daß die Mikrowellen-Fenster-Ebene, die im Ausführungsbeispiel rechtwinklig zur Längsmittelachse L verläuft, etwa mittig zwischen den Auflage- oder Befestigungsseiten der beiden Substrathalter 3, 3a verläuft.
Mit der Möglichkeit der gleichzeitigen Beschichtung zweier Substrate in einem Reaktorgehäuse kann besonders wirtschaftlich gearbeitet werden.

## Patentansprüche

1. Plasmareaktor mit einem als Resonator ausgebildeten Reaktorgehäuse (2), an das eine mit einem Hochfrequenzgenerator (6) verbundene Hochfrequenz-Koaxialleitung (5) zur Einstrahlung von Mikrowellen angeschlossen ist und in dem sich ein Substrathalter (3) für ein zu beschichtendes Substrat befindet, wobei im Übergangsbereich von der Hochfrequenz-Koaxialleitung in das Reaktorgehäuse (2) ein vakuumdichtes Fenster (12) aus mikrowellendurchlässigem Material angeordnet ist und wobei das Reaktorgehäuse (2) Anschlüsse (10,11) zum Zu-und Ableiten eines Prozeßgases aufweist, **dadurch gekennzeichnet, daß** die Hochfrequenz-Koaxialleitung (5) an ihrem zuleitungsende außerhalb des Reaktorgehäuses (2) trichterförmig und im wesentlichen rotationssymmetrisch aufgeweitet und am Umfang des Reaktorgehäuses (2) gegen das im wesentlichen ringförmige, in Umfangsrichtung durchgehende Mikrowellen-Fenster (12) für eine auf die gesamte Ringfläche des Mikrowellen-Fensters (12) verteilte Einkopplung gerichtet ist.

2. Plasmareaktor nach Anspruch 1, **dadurch gekennzeichnet, daß** das Reaktorgehäuse (2) in zwei voneinander elektrisch isolierte Teilgehäuse (2a,2b) aufgeteilt ist, daß mit zumindest einem dieser Teilgehäuse (2a) ein Substrathalter (3) verbunden ist und daß das andere, davon elektrisch isolierte Teilgehäuse (2b) als Elektrode für eine Gleichspannungs- beziehungsweise Hochfrequenzentladung dient.

3. Plasmareaktor nach Anspruch 1 oder 2, **dadurch gekennzeichnet, daß** das Mikrowellen-Fenster (12) aus elektrisch isolierendem, mikrowellendurchlässigen Material, vorzugsweise Quarz besteht und zwischen den beiden Teilgehäusen (2a,2b) als Isolator eingefügt ist.

4. Plasmareaktor nach einem der Ansprüche 1 bis 3, **dadurch gekennzeichnet, daß** das mit dem Substrathalter (3) verbundene Teilgehäuse (2a) die Anschlüsse zum Zu-und Ableiten eines Prozeßgases aufweist und daß diesem Teilgehäuse gegebenenfalls eine Substrat-Kühleinrichtung (7) sowie bedarfsweise Zusatzeinrichtungen insbesondere zur Positionierung des Substrathalters (3) zugeordnet sind.

5. Plasmareaktor nach einem der Ansprüche 1 bis 4, **dadurch gekennzeichnet, daß** der Anschluß (10) zum Zu-beziehungsweise Ableiten eines Prozeßgases dem Substrathalter (3) gegenüberliegend angeordnet und vorzugsweise etwa mittig auf den Substrathalter (3) gerichtet ist.

6. Plasmareaktor nach einem der Ansprüche 1 bis 5, **dadurch gekennzeichnet, daß** das Reaktorgehäuse (2) rotationssymmetrisch bezüglich einer Längsmittelachse (L) ausgebildet ist, daß die Teilgehäuse (2a,2b) des Reaktorgehäuses (2) eine quer, vorzugsweise rechtwinklig zur Längsmittelachse (L) verlaufende Trennebene aufweisen und daß das ringförmige Mikrowellen-Fenster (12) in dieser Trennebene angeordnet ist.

7. Plasmareaktor nach einem der Ansprüche 1 bis 6, **dadurch gekennzeichnet, daß** mit beiden Teilgehäusen (2a,2b) jeweils vorzugsweise ein Substrathalter (3,3a) verbunden ist und daß diese Substrathalter (3,3a) insbesondere direkt gegenüberliegend und vorzugsweise beide in einem gemeinsamen Bereich hoher Feldstärke angeordnet sind.

8. Plasmareaktor nach einem der Ansprüche 1 bis 7, **dadurch gekennzeichnet, daß** das Mikrowellen-Fenster (12) in einer Ebene liegt, die sich bei einem in einem Teilgehäuse (2a) befindlichen Substrathalter (3) beabstandet zur Auflageoder Befestigungsseite des Substrathalters (3) und bei gegenüberliegend angeordneten Substrathaltern (3,3a) vorzugsweise mittig zwischen deren Auflage- oder Befestigungsseiten befindet.

9. Plasmareaktor nach einem der Ansprüche 1 bis 8, **dadurch gekennzeichnet, daß** die an ihrem Zuleitungsende außerhalb des Reaktorgehäuses (2) aufgeweitete Hochfrequenz-Koaxialleitung (5) im Übergangsbereich zum Reaktorgehäuse (2) zentral an einen flachen, tellerförmigen Hohlleiterabschnitt (14) angeschlossen ist, an den sich außenseitig ein ringförmiger und mit seinem Austrittsende dem Mikrowellen-Fenster (12) außenseitig zugewandter Umlenk-Hohlleiterabschnitt (16) anschließt.

## Claims

1. Plasma reactor having a reactor housing (2) constructed as a resonator, to which a high frequency coaxial lead (5) connected to a high frequency generator (6) is attached for beaming in microwaves and wherein there is a substrate holder (3) for a substrate which is to be coated, while in the transitional zone from the high frequency coaxial lead into the reactor housing (2) there is provided a vacuum-tight window (12) made of microwave-permeable material and the reactor housing (2) has connections (10, 11) for the entry and exit of a process gas, **characterised in that** the high frequency coaxial lead (5) widens out in a funnel-shape and in substantially rotationally symmetrical manner at its entry end outside the reactor housing (2) and, on the periphery of the reactor housing (2), is directed towards the substantially annular microwave window (12) which extends continuously in the circumferential direction for a coupling distributed over the entire annular surface of the microwave window (12).

2. Plasma reactor according to claim 1, **characterised in that** the reactor housing (2) is divided into two housing sections (2a, 2b) electrically insulated from each other, **in that** a substrate holder (3) is connected to at least one of these housing sections (2a) and the other housing section (2b) which is electrically insulated therefrom serves as an electrode for d.c. or high frequency discharge.

3. Plasma reactor according to claim 1 or 2, **characterised in that** the microwave window (12) consists of electrically insulating microwave-permeable material, preferably quartz, and is interposed between the two housing sections (2a, 2b) as an insulator.

4. Plasma reactor according to one of claims 1 to 3, **characterised in that** the housing section (2a) connected to the substrate holder (3) contains the connections for the entry and exit of a process gas and **in that** a substrate cooling device (7) and, if necessary, additional devices particularly for positioning the substrate holder (3) are optionally associated with this housing section.

5. Plasma reactor according to one of claims 1 to 4, **characterised in that** the connection (10) for the entry or exit of a process gas is arranged opposite the substrate holder (3) and is preferably arranged substantially centrally on the substrate holder (3).

6. Plasma reactor according to one of claims 1 to 5, **characterised in that** the reactor housing (2) is constructed to be rotationally symmetrical with respect to a central longitudinal axis (L), the housing sections (2a, 2b) of the reactor housing (2) have a plane of separation extending transversely, preferably at right angles to the central longitudinal axis (L) and the annular microwave window (12) is located in this plane of separation.

7. Plasma reactor according to one of claims 1 to 6, **characterised in that** there is preferably a substrate holder connected to each of the two housing sections (2a, 2b) and these substrate holders (3, 3a) are arranged, in particular, directly opposite and preferably both in a common area of high field intensity.

8. Plasma reactor according to one of claims 1 to 7, **characterised in that** the microwave window (12) is located in a plane which, in the case of a substrate holder (3) located in a housing section (2a), is arranged at a spacing from the contact or attachment side of the substrate holder (3) and, in the case of substrate holders (3, 3a) arranged opposite each other, is preferably located midway between their contact or attachment sides.

9. Plasma reactor according to one of claims 1 to 8, **characterised in that** the high frequency coaxial lead (5) which widens out at its entry end outside the reactor housing (2) is attached centrally, in the zone of transition to the reactor housing (2), to a flat, plate-shaped hollow lead section (14) to which is externally attached an annular deflecting hollow lead section (16) on the outside facing the microwave window (12) with its exit end.

## Revendications

1. Réacteur à plasma comportant un carter de réacteur (2) se présentant sous la forme d'un résonateur auquel est raccordée une ligne coaxiale à haute fréquence (5) reliée à un générateur à haute fréquence (6) pour l'émission de micro-ondes et dans lequel se trouve un porte-substrat (3) pour un substrat à enduire, une fenêtre étanche au vide (12) en matériau perméable aux micro-ondes étant disposée dans la zone de passage de la ligne coaxiale à haute fréquence dans le carter de réacteur (2) et le carter de réacteur (2) présentant des raccords (10, 11) pour l'amenée et l'évacuation d'un gaz de procédé, **caractérisé par le fait que** la ligne coaxiale à haute fréquence (5) est évasée en forme d'entonnoir et essentiellement symétrique de révolution à son extrémité d'amenée à l'extérieur du carter de réacteur (2) et, dirigé sur la périphérie du carter de réacteur (2), contre la fenêtre à micro-ondes (12) essentiellement annulaire, continue dans la direction périphérique, pour un couplage réparti sur toute la surface annulaire de la fenêtre à micro-ondes (12).

2. Réacteur à plasma selon la revendication 1, **caractérisé par le fait que** le carter de réacteur (2) est divisé en deux sous-carters (2a, 2b) électriquement isolés l'un de l'autre, qu'un porte-substrat (3) est relié à au moins un de ces sous-carters (2a) et que l'autre sous-carter (2b), électriquement isolé du premier, sert d'électrode pour une décharge de tension continue et à haute fréquence.

3. Réacteur à plasma selon la revendication 1 ou 2, **caractérisé par le fait que** la fenêtre à micro-ondes (12) est constituée d'un matériau électriquement isolant, perméable aux micro-ondes, de préférence du quartz, et interposée comme isolant entre les deux sous-carters (2a, 2b).

4. Réacteur à plasma selon l'une des revendications 1 à 3, **caractérisé par le fait que** le sous-carter (2a) relié au porte-substrat (3) présente les raccords pour l'amenée et l'évacuation d'un gaz de procédé et qu'à ce sous-carter sont associés, le cas échéant, un dispositif de refroidissement du substrat (7) ainsi que, en cas de besoin, des dispositifs supplémentaires permettant en particulier le positionnement du porte-substrat (3).

5. Réacteur à plasma selon l'une des revendications 1 à 4, **caractérisé par le fait que** le raccord (10) d'amenée ou d'évacuation d'un gaz de procédé est placé vis-à-vis du porte-substrat (3) et de préférence à peu près centré par rapport au porte-substrat (3).

6. Réacteur à plasma selon l'une des revendications 1 à 5, **caractérisé par le fait que** le carter de réacteur (2) présente une symétrie de révolution par rapport à un axe central longitudinal (L), que les sous-carters (2a, 2b) du carter de réacteur (2) présentent un plan de séparation transversal, de préférence perpendiculaire à l'axe central longitudinal (L), et que la fenêtre à micro-ondes annulaire (12) est située dans ce plan.

7. Réacteur à plasma selon l'une des revendications 1 à 6, **caractérisé par le fait que** les deux sous-carters (2a, 2b) sont de préférence reliés chacun à un porte-substrat (3, 3a) et que ces porte-substrats (3, 3a) sont en particulier placés directement l'un vis-à-vis de l'autre et de préférence situés tous deux dans une même région d'intensité de champ élevée.

8. Réacteur à plasma selon l'une des revendications 1 à 7, **caractérisé par le fait que** la fenêtre à micro-ondes (12) se trouve dans un plan qui, dans le cas d'un porte-substrat (3) situé dans un sous-carter (2a), est éloigné du côté d'appui ou de fixation du porte-substrat (3) et qui, dans le cas de porte-substrats placés l'un vis-à-vis de l'autre (3, 3a), est de préférence centré entre leurs côtés d'appui ou de fixation.

9. Réacteur à plasma selon l'une des revendications 1 à 8, **caractérisé par le fait que** la ligne coaxiale à haute fréquence (5) évasée en forme d'entonnoir à son extrémité d'amenée à l'extérieur du carter de réacteur (2) est raccordée en position centrale, dans la zone de transition avec le carter de réacteur (2), à un tronçon de guide d'ondes plat, en forme de disque (14), auquel se raccorde extérieurement un tronçon de guide d'ondes de renvoi (16), de forme annulaire et tourné extérieurement par son extrémité de sortie vers la fenêtre à micro-ondes (12).
